# EUROPEAN PATENT SPECIFICATION

(11) **EP 0 349 095 B1**
(45) Date of publication and mention of the grant of the patent: **19.05.1999**
(21) Application number: 89202084.3
(22) Date of filing: 23.02.1983
(51) Int. Cl.: H01L 21/607, H01L 23/49, B23K 20/00

(54) **Metal wire for use in integrated circuits**
Metalldraht für integrierte Schaltungen
Fil métallique pour circuits intégrés

(30) Priority: 10.03.1982 JP 36468/82
(43) Date of publication of application: 03.01.1990
(62) Divisional of application: 83300956.6
(73) Proprietor: HITACHI, LTD., Chiyoda-ku, Tokyo (JP)
(72) Inventor: Onuki, Jin, Hitachi-shi Ibaraki-ken (JP); Suwa, Masateru, Naka-gun Ibaraki-ken (JP); Koizumi, Masahiro, Hitachi-shi Ibaraki-ken (JP); Iizuka, Tomio, Naka-gun Ibaraki-ken (JP); Tamamura, Takeo, Hitachi-shi Ibaraki-ken (JP)
(74) Representative: Paget, Hugh Charles Edward

(56) References cited:
- EP-A- 0 043 692
- FR-A- 2 063 196
- US-A- 3 357 090
- US-A- 3 838 240
- US-A- 4 213 556
- PATENT ABSTRACTS OF JAPAN, vol. 6, no. 72 (E-105)[950], 7th May 1982 & JP-A-57 012 531
- PHYSICAL METALLURGY PRINCIPLES, pub. Van Nostrand Reinhold 1970, pgs. 179,194,195 & 197
- MANUFACTURING ENGINEERING AND TECHNOLOGY, pub. Addison-Wesley; S. Kalpakjian, p. 65
- FUNDAMENTALS OF ENGINEERING MATERIALS, pub. Prentice-Hall 1992; P. Thornton, pp. 162-163, 470-472

## Description

The present invention relates to a metal wire having a ball at a tip thereof for use in integrated circuits, and to a method of making such a wire.

In resin encapsulated semiconductor devices (such as an IC, LSI or transistor, Au wire of diameter of 20 - 50 µm is generally employed for the electrical connection between the semiconductor element and the external lead frame of the package. To bond the wire to the semiconductor element, there are two methods, wedge bonding and ball bonding. In these bonding methods, one end of the Au wire, or a ball formed at the end of the Au wire through fusion thereof by means of a discharge or hydrogen flame, is bonded to the semiconductor element directly or through a deposited metallic film by thermocompression bonding or ultrasonic bonding. The connection of the other end of the wire to the lead frame is effected by wedge bonding using a capillary tube.

The use of Al wire instead of Au wire has been studied, since Au wire is expensive. For Al wire, wedge bonding by means of thermo-compression bonding or ultrasonic bonding has also been investigated. However, conventional Al wire, when used as it has been drawn, retains a hardness caused by the drawing. The present inventors have found that in both thermo-compression bonding and ultrasonic bonding of Al wire, the part of the wire near the bonded portion is softened by heating, so that a local deformation takes place at the bonding portions in the connection of the wire from the semiconductor element to the lead frame, and that such a local deformation not only causes the wire to be locally reduced but also may result in breakage or the like.

Moreover, the present inventors have discovered, as a result of examination of ball bonding of Al wire, that since conventional Al wire is wound on a reel as it has been drawn, the wire is elastically bent when a ball is formed at its end and the ball is eccentrically formed. Furthermore, since when the ball is formed not only the end but also the vicinity of the end is heated, the portion of the wire directly above the ball is subjected to annealing and, consequently becomes softened or locally constricted.

The inventors have also found that the eccentricity of the ball may cause the bonding portion to project from a pad, bringing about a short-circuit with another bonding portion or damage to the circuit.

Furthermore, the inventors have discovered that if a constriction is produced directly above the ball or if the wire softens, since the portion not annealed remains work-hardened, the residual work set of the wire prevents the wire and the bonding portion from occupying a fine curve, so that the wire is bonded in a bent shape, which may cause breakage of the wire, particularly in a dual in-line type IC or LSI having a difference in level between the bonding surfaces of the semiconductor element and the lead frame. This may cause a short-circuit between the wire and the semiconductor element.

In resin encapsulated semiconductor devices a larger mechanical stress is applied to the wire because it is rigidly moulded with thermosetting resins such as epoxy resins, phenol resins, polyester resins, etc. The mechanical stress is maximum at the bonding position on the semiconductor chip. Thus, it has now been found that in resin encapsulated semiconductor devices the nature of the wire materials play a very important role in the production of a satisfactory ball bonding connection.

Patent abstracts of Japan, volume 6, No. 72 (E-105) (950), and JP-A-57-12531 disclose improvement of the elongation of a fine Al wire by heating between 150°C and 400°C. EP-A-043692 discloses a method of forming a ball on a wire by spark discharge by initiating an arc using a high voltage, low current source and then drawing current to form the ball using a low voltage, high current source. It also discloses an apparatus suitable for use in such a method.

It is an object of the invention to provide a wire having a ball at its tip which permits good connections to be formed in an integrated circuit and with which there is a low risk of breakage of the wire.

The present invention is set out in claims 1 and 5.

Aspects of the prior art and embodiments of the present invention will now be described by way of example with reference to the accompanying drawings, in which:-
Fig. 1 is a sectional view of a semiconductor device with a wire having a ball-bonded connection at one end and a wedge-bonded connection at the other end;
Fig. 2(a) is a sectional view indicating a further step following Fig. 1 in wedge-bonding;
Fig. 2(b) is a sectional view showing how a ball is formed by discharge;
Fig. 3 is a sectional view of a resin molded type semiconductor device; and
Fig. 4 is a bar graph showing the relationship between conventional wires and wires of the present invention, on the one hand, and the percentage of production of eccentricity and the percentage of production of ecccentricity and constriction, on the other hand.

Since a wire made of a metal having in the annealed state an elongation at room temperature of not more than 60% is very highly work-hardened in the worked state (i.e. after the wire has been worked), it is difficult to destroy the oxide film formed on the surface of the ball in thermo-compression bonding or ultrasonic bonding, so that bonding is difficult. Moreover, since the vicinity of the bonding portion is softened by heating during bonding as described above, the local deformation is especially large. It has now been discovered that it is necessary to anneal the wire made of a metal having such an elongation so that it becomes softer. Annealing permits the wire to be softened throughout, so that there is no possibility of local deformation, and consequently, problems such as disconnection are solved.

The wire used in the present invention is Al wire or Cu wire. It is preferable to employ a wire having a specific resistance at room temperature (20°C) of not more than 15 µΩcm.

The wire of the present invention is used for ball bonding which can be effected by ultrasonic bonding or thermo-compression bonding. Ball bonding is especially effective in the case of a semiconductor element which is a circuit element, because bonding distance is limited and the necessity to turn the semiconductor device is avoided. On the other hand, where there is an external terminal, wedge bonding is preferable and can achieve high efficiency.

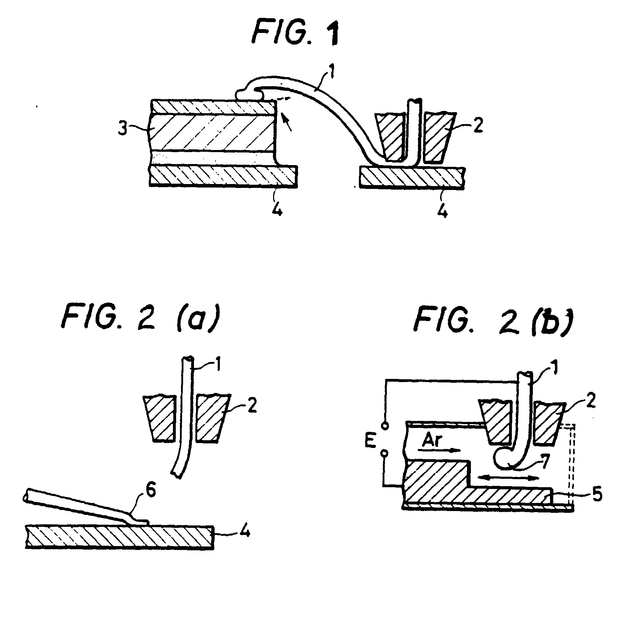

Figs. 1 and 2(a) illustrate wedge-bonding. A wire 1 emerges from a capillary feeder 2, the bottom end of which is used to effect the wedge-bonding, as Figs. 1 and 2(a) show. After the bonding step, the capillary 2 is removed to break the wire, leaving a bonded portion 6 attached to the Cu lead frame 4. The lead frame may alternatively be a Fe-Ni alloy. Fig. 1 shows the other end of the wire 1 ball-bonded to a metal layer on the top of the semiconductor element 3, which is itself mounted on another part of the lead frame 4.

Fig. 2(b) shows how, in ball-bonding the ball 7 is formed using the surface tension of the wire itself by fusing the end of the wire held by a capillary 2 by means of are discharge, hydrogen flame, plasma arc, or a laser beam. Particularly preferred, as illustrated in Fig. 2(b) is arc discharge between the wire itself and a separate electrode 5. The arc discharge is performed with the wire at minus polarity, whereby a clean ball having no oxide film on its surface is formed. In addition, it is possible to supply a pulse current of at least one of positive and negative pulses in the arc discharge. The pulse current permits control of the correct arc-generating time necessary for formation of a ball. When supplying a current of positive and negative pulses, control can be effected by converting the time required for cleaning and the time required for formation of a ball into a time ratio between positive and negative. The time required for cleaning accounts for about 10 - 30% of the discharge time.

It is preferable that the heating-fusing atmosphere in ball formation is a non-oxidising atmosphere. Particularly preferred is an inert gas including a small amount, preferably 5 - 15 vol.% of a reducing gas (e.g. hydrogen gas). The inclusion of such a reducing gas is preferable for a metal having a high affinity to oxygen, such as Zr or the Al. Especially, for Al it is preferable to employ an atmosphere including 5 - 15 vol.% hydrogen gas.

Fig. 2(b) shows how the ball 7 may be eccentrically formed.

Although any ball diameter is in principle useful, preferred are diameters 1.5 - 4 times, particularly 2.5 - 3.5 times, as large as the wire diameter.

The wire diameter range used in the invention is 20 - 100 µm, although this varies according to the kind of metal. For example, the Al wire diameter may be about 50 µm, while the Cu wire diameter may be about 30 µm. The wire diameter is selected in relation to the specific resistance.

The annealing temperature is higher than the recrystallization temperature of the metal, although it differs according to the kind of metal. It is particularly preferred to employ a temperature at which the wire is substantially full-annealed to an extent that it is not elastically deformed, i.e. contains substantially no elastic deformation. The wire is softened so as to have the same hardness throughout, since if the wire locally has a difference in hardness, a local deformation is produced, as described above. Annealing temperatures are 150 - 400°C for Al and 400 - 600°C for Cu.

Although it is conceivable to anneal a wire which has already been bonded to a circuit element in its worked state, it is far more efficient to bond a wire previously annealed, as required by the present invention.

The wire, after being bonded to a circuit element, may be cut in the vicinity of the bonded portion of the circuit element by holding the wire in a capillary and pulling it (Fig.2(a)). It may be difficult to cut the wire in the vicinity of the circuit element, since the wire itself is soft throughout, in which case it is preferable to cut the wire with a cutter.

Since the wire usually has an extremely small diameter and is soft as described above, the semiconductor element, the wire and a part of the external terminal are covered with resin in order to protect the wire. Typically, liquid resin is case or molded and then hardened.

### Example

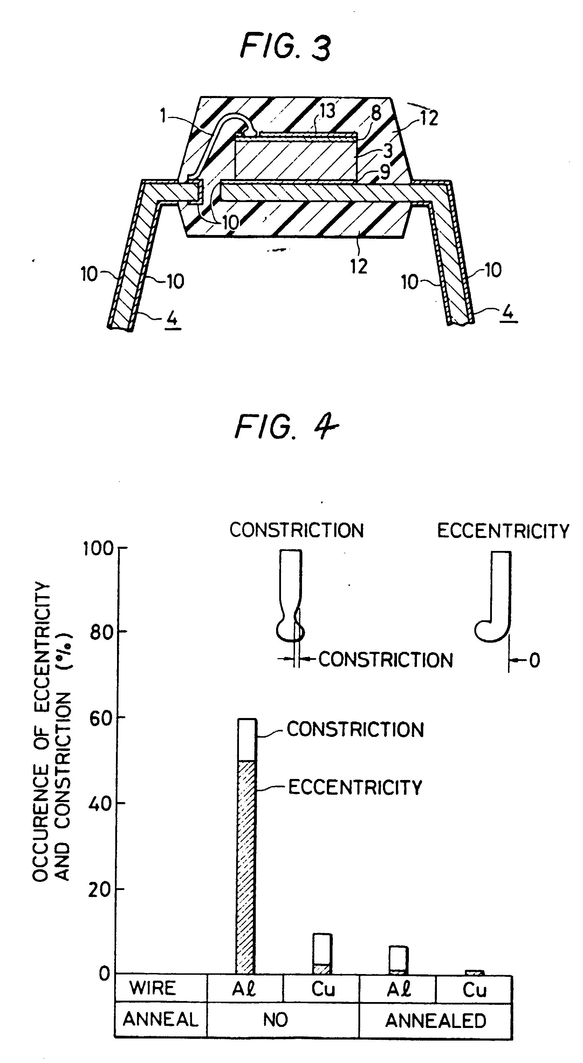

Fig. 3 is a sectional view of a resin-encapsulated type semiconductor device having an annealed Al wire 1. The Al wire is previously subjected, prior to bonding, to a full annealing of 1-hour heating at 250°C in N₂ gas. The Al wire 1 is then ball-bonded to the semiconductor element 3 which is provided with an Al deposited film 8, while the wire 1 is wedge-bonded to the lead frame 4 which is provided with an Ag or Ni deposited layer 10. After the ball bonding, a protective film 13 such as SiO₂ is provided on the layer 8. Then, a thermosetting resin composition 12 is transfer-molded to form the semiconductor device shown in Fig. 3. A low-melting glass 9 may be used to mount the semiconductor element 3.

During the bonding, the Al wire is extruded through a capillary 2 as shown in Figs. 2(a) and 2(b). Al wire described above was subjected to discharge under discharge conditions of 1,000V and 10 - 20 mA in the atmosphere replaced, after evacuation, with an Ar gas atmosphere including 7% (volume) hydrogen, in order to form a ball at its end. The discharge was effected by moving a separately provided W electrode 5 relatively to the wire. The time for ball formation was controlled by the speed of movement of the electrode and a correctly determined frequency of pulsed energization. Moreover, the energization was performed by means of a pulse current of positive and negative pulses, with the energisation made less on the side of cleaning the wire. The ball obtained was ultrasonically bonded to the semiconductor element by means of the capillary 2, and then the other end was similarly ultrasonically bonded to the lead frame 4.

Although the ball obtained by this method had the shape of an oval slightly longer in the axial direction of the wire, it was close to an excellent sphere. It has been confirmed that the ball is substantially equal in hardness to the wire itself, and it is possible to achieve a good loop-shaped connection wire without any local deformation in the vicinity of the ball, as shown in Fig. 3. In addition, although the cutting of the wire after wedge bonding is effected by lifting the capillary in order to pull the wire, the cutting was extremely easy because the wire was soft and moreover, the pulling did not cause any problems such as exfoliation of the bonding portion.

Since the illustrated semiconductor device suffers no local deformation of the wire in ball bonding and consequently a desired loop shape can be obtained, there is a minimal possibility of disconnection due to local deformation and moreover, there was no defect such as short-circuit of the wire with the element.

### Production of balls at wire ends for bonding

A ball was formed by the method of Fig. 2(b) at the end of each of a Cu wire having a diameter of 30 µm and remaining as it has been worked and a wire obtained by subjecting such a wire to a full annealing of 1-hour heating at 400°C in Ar gas.

The discharge was effected under a voltage of 1000V, a current of 10 - 20 mA and in Ar gas. The discharge time was controlled by the speed of movement of the W electrode 5 and the pulse frequency, as described above.

In a similar manner to the above, a ball was formed at the end of each of an Al wire having a diameter of 50 µm and remaining as it has been worked and a wire obtained by subjecting such an Al wire to a full annealing of 1-hour heating at 250°C. The discharge conditions were substantially the same as for the Cu wires, except that the discharge current was 1 to 10 mA.

For each of these types of Cu and Al wires, 50 balls were formed, and the number of the balls having constrictions and eccentricity was examined and then the percentage thereof was obtained. The results are shown in Fig. 4.

Fig. 4 shows that the Al wire remaining as it has been worked exhibits a constriction level of 60% and eccentricity level of 50%, while the annealed Al wire exhibits a constriction level of only 7% and an eccentricity level of the order of a few %. It forms a round ball symmetrical with respect to the wire axis. Moreover, although the Cu wire is better than the Al wire even when the Cu wire remains as it has been worked, the annealed Cu wire exhibits hardly any constriction and eccentricity.

The formation of the ball for the above-described annealed Al wire was examined in a similar way to the above, with the gas atmosphere during ball-forming. Ar was mixed with amounts of H₂ gas up to 50 vol.% and the relation between the mixing percentage and the quality of ball formation state was examined. The results showed that the ball formation was best when the H₂ quantity was 5 - 15 vol.%. In this case, energization was effected also by making the wire positive or negative besides the above-described pulse current. The results showed that energization by the pulse current made it easy to control the ball diameter and moreover allowed a clean ball to be obtained.

Thus, by the present invention, it is possible to obtain a wire connection having no local deformation at the bonding portion of the wire.

## Claims

1. A metal wire having a ball (7) at a tip thereof for use in integrated circuits, the wire (1) having a diameter of 20 to 100 µm and being an Al wire or a Cu wire and the wire (1) having been annealed at a temperature higher than the recrystallization temperature of the metal material and having a maximum elongation of not more than 60% at room temperature (20°C), said ball (7) of said metal wire (1) being spherical in shape, having a hardness substantially equal to that of said metal wire (1), and being symmetrical with respect to the axis of said wire, said wire having substantially no local constriction at its tip adjacent to the ball.

2. A metal wire according to claim 1 which has a specific resistance of not more that 15 µΩ cm at room temperature.

3. A metal wire according to claim 1 or claim 2 wherein the diameter of said ball (7) is 1.5 to 4 times that of said metal wire (1).

4. A metal wire according to claim 3, wherein the diameter of said ball (7) is 2.5 to 3.5 times that of said metal wire (1).

5. A method of manufacture of a metal wire (1) having a ball (7) at a tip thereof for use in integrated circuits, wherein the ball is formed by melting the tip of a metal wire (1) by means of arc discharge, hydrogen flame, plasma arc or laser beam, said metal wire being an Al wire or a Cu wire, having a diameter of 20 to 100 µm and having been annealed prior to the ball formation at a temperature higher than the recrystallisation temperature of the metal material, wherein the maximum elongation of the wire after annealing is not more than 60% at room temperature (20°), the ball is spherical in shape, has a hardness substantially equal to that of the metal wire and is symmetrical with respect to the axis of the wire, said wire having substantially no local constriction at its tip adjacent to the ball.

6. A method according to claim 5 wherein, prior to the ball formation, the wire is annealed at a temperature from 150 to 400°C in the case of Al wire and at a temperature from 400 to 600°C in the case of Cu wire.

7. A method according to claim 5 or claim 6 wherein said ball (7) is formed by bringing the wire tip into the vicinity of an electrode (5) to which a potential is applied and effecting arc discharge between the tip of said metal wire (1) and the electrode (5) to melt the tip of said metal wire (1) in a non-oxidizing atmosphere to form the ball.

8. A method according to claim 7 including
supplying a pulse current of at least one of positive pulses and negative pulses in the arc discharge, and
controlling the arc generating time necessary for formation of said ball (7) by means of the pulse current.

9. A method according to claim 7 including
supplying a pulse current of positive pulses and negative pulses in the arc discharge; and
controlling the ratio of time for cleaning and a time for formation of said ball (7) by selecting the time ratio between the positive pulses and the negative pulses.

10. A method according to any one of the claims 5 to 9 wherein the atmosphere present during the formation of said ball (7) is a non-oxidizing atmosphere.

11. A method according to claim 10 wherein the non-oxidizing atmosphere is an inert gas including reducing gas.

12. A method according to claim 11 wherein the inert gas includes 5-15 vol.% of hydrogen gas.

13. A method according to any one of claims 5 to 12 wherein the diameter of said ball (7) is 1.5 to 4 times that of said metal wire (1).

14. A method according to claim 13 wherein the diameter of said ball (7) is 2.5 to 3.5 times that of said metal wire (1).

## Patentansprüche

1. Metalldraht für integrierte Schaltungen (7) mit einem Kopf (7) an der Spitze, wobei der Draht (1) einen Durchmesser von 20 bis 100 µm besitzt und aus Al oder Cu besteht und bei einer Temperatur oberhalb der Rekristallisationstemperatur des Metalls geglüht ist und eine maximale Längendehnung von höchstens 60% bei Raumtemperatur (20°C) besitzt, wobei der Kopf (7) des Metalldrahts (1) sphärische Form besitzt, eine im wesentlichen gleiche Härte wie der Metalldraht (1) aufweist und, bezogen auf die Drahtachse, symmetrisch ist, und wobei der Draht im wesentlichen keine lokale Einschnürung an seiner zum Kopf benachbarten Spitze aufweist.

2. Metalldraht nach Anspruch 1 mit einem spezifischen Widerstand von höchstens 15 µΩ cm bei Raumtemperatur.

3. Metalldraht nach Anspruch 1 oder 2, dadurch gekennzeichnet, daß der Durchmesser des Kopfes (7) das 1,5 bis 4-fache desjenigen des Metalldrahts (1) beträgt.

4. Metalldraht nach Anspruch 3, dadurch gekennzeichnet, daß der Durchmesser des Kopfes (7) das 2,5 bis 3,5-fache desjenigen des Metalldrahts (1) beträgt.

5. Verfahren zur Herstellung eines Metalldrahts (1) für integrierte Schaltkreise mit einem Kopf (7) an der Spitze, dadurch gekennzeichnet, daß der Kopf durch Schmelzen der Spitze des Metalldrahts (1) mittels einer Bogenentladung, einer Wasserstoffflamme, eines Plasmabogens oder eines Laserstrahls hergestellt wird, wobei der Metalldraht aus Al oder Cu besteht, einen Durchmesser von 20 bis 100 µm aufweist und vor dem Herstellen des Kopfes bei einer Temperatur oberhalb der Rekristallisationstemperatur des Metalls geglüht wurde, daß die maximale Längendehnung des Drahtes nach dem Glühen höchstens 60% bei Raumtemperatur (20°C) beträgt, der Kopf sphärische Form besitzt und eine im wesentlichen gleiche Härte wie die des Metalldrahts aufweist und in bezug auf die Drahtachse symmetrisch ist, wobei der Draht im wesentlichen keine lokale Einschnürung an seiner zum Kopf benachbarten Spitze aufweist.

6. Verfahren nach Anspruch 5, dadurch gekennzeichnet, daß vor der Herstellung des Kopfes der Al-Draht bei einer Temperatur zwischen 150 und 400°C und im Falle eines Cu-Drahts dieser bei einer Temperatur zwischen 400 und 600°C geglüht wird.

7. Verfahren nach Anspruch 5 oder 6, dadurch gekennzeichnet, daß der Kopf (7) dadurch gebildet wird, daß die Drahtspitze in die Nähe einer Elektrode (5) gebracht wird, an die eine Spannung angelegt wird, und daß zwischen der Spitze des Metalldrahts (1) und der Elektrode (5) eine Bogenentladung ausgelöst wird, die die Spitze des Metalldrahts (1) in einer nicht-oxidierenden Atmosphäre schmelzt, wodurch der Kopf gebildet wird.

8. Verfahren nach Anspruch 7, bei dem in die Bogenentladung ein Pulsstrom mit mindestens einem positiven und einem negativen Puls eingebracht wird, und bei dem
die zur Bildung des Kopfes (7) notwendige Bogenerzeugungsdauer mittels des Pulsstromes gesteuert wird.

9. Verfahren nach Anspruch 7, bei dem in die Bogenentladung ein Pulsstrom mit positiven und negativen Pulsen eingebracht wird, und bei dem
das Verhältnis der Zeit zum Reinigen und der Zeit für die Bildung des Kopfes (7) durch Auswahl eines Zeitverhältnisses zwischen positiven und negativen Pulsen gesteuert wird.

10. Verfahren nach einem der Ansprüche 5 bis 9, dadurch gekennzeichnet, daß die während der Bildung des Kopfes (7) vorhandene Atmosphäre nicht-oxidierend ist.

11. Verfahren nach Anspruch 10, bei dem die nicht-oxidierende Atmosphäre ein Inertgas mit reduzierendem Gas ist.

12. Verfahren nach Anspruch 11, bei dem das Inertgas 5-15 Vol.% Wasserstoffgas enthält.

13. Verfahren nach einem der Ansprüche 5 bis 12, bei dem der Durchmesser des Kopfes (7) das 1,5 bis 4-fache des Durchmessers des Metalldrahts (1) beträgt.

14. Verfahren nach Anspruch 13, bei dem der Durchmesser des Kopfes (7) das 2,5 bis 3,5-fache desjenigen des Metalldrahts (1) beträgt.

## Revendications

1. Fil métallique ayant une bille (7) à une extrémité de celui-ci, destiné à être utilisé dans des circuits intégrés, le fil (1) ayant un diamètre de 20 à 100 µm et étant un fil d'Al ou un fil de Cu et le fil (1) ayant été recuit à une température supérieure à la température de recristallisation du matériau métallique et ayant un allongement maximal ne dépassant pas 60 % à température ambiante (20°C), ladite bille (7) dudit fil métallique (1) étant sphérique en termes de forme, ayant une dureté sensiblement égale à celle dudit fil métallique (1), et étant symétrique par rapport à l'axe dudit fil, ledit fil n'ayant sensiblement aucune constriction locale à son extrémité adjacente à la bille.

2. Fil métallique selon la revendication 1 qui a une résistance spécifique ne dépassant pas 15 µΩ cm à température ambiante.

3. Fil métallique selon la revendication 1 ou la revendication 2 dans lequel le diamètre de ladite bille (7) est 1,5 à 4 fois celui dudit fil métallique (1).

4. Fil métallique selon la revendication 3, dans lequel le diamètre de ladite bille (7) est 2,5 à 3,5 fois celui dudit fil métallique (1).

5. Procédé de fabrication d'un fil métallique (1) ayant une bille (7) à une extrémité de celui-ci, destiné à être utilisé dans des circuits intégrés, dans lequel la bille est formée en faisant fondre l'extrémité d'un fil métallique (1) au moyen d'une décharge en arc, d'un chalumeau à hydrogène, d'un arc au plasma ou d'un faisceau laser, ledit fil métallique étant un fil d'Al ou un fil de Cu, ayant un diamètre de 20 à 100 µm et ayant été recuit avant la formation de la bille à une température supérieure à la température de recristallisation du matériau métallique, dans lequel l'allongement maximal du fil après recuit ne dépasse pas 60 % à température ambiante (20°), la bille est sphérique en termes de forme, a une dureté sensiblement égale à celle du fil métallique et est symétrique par rapport à l'axe du fil, ledit fil n'ayant sensiblement aucune constriction locale à son extrémité adjacente à la bille.

6. Procédé selon la revendication 5 dans lequel, avant la formation de la bille, le fil est recuit à une température de 150 à 400°C dans le cas du fil d'Al et à une température de 400 à 600°C dans le cas du fil de Cu.

7. Procédé selon la revendication 5 ou la revendication 6 dans lequel ladite bille (7) est formée en amenant l'extrémité du fil au voisinage d'une électrode (5) sur laquelle un potentiel est appliqué et en effectuant une décharge en arc entre l'extrémité dudit fil métallique (1) et l'électrode (5) afin de faire fondre l'extrémité dudit fil métallique (1) dans une atmosphère non-oxydante pour former la bille.

8. Procédé selon la revendication 7 consistant à délivrer un courant impulsionnel composé d'impulsions positives et/ou d'impulsions négatives dans la décharge en arc, et
commander le temps de production de l'arc nécessaire à la formation de ladite bille (7) au moyen du courant impulsionnel.

9. Procédé selon la revendication 7 consistant à déliver un courant impulsionnel composé d'impulsions positives et d'impulsions négatives dans la décharge en arc, et
commander le rapport du temps de nettoyage et du temps de formation de ladite bille (7) en sélectionnant le rapport de temps entre les impulsions positives et les impulsions négatives.

10. Procédé selon l'une quelconque des revendications 5 à 9 dans lequel l'atmosphère présente durant la formation de ladite bille (7) est une atmosphère non-oxydante.

11. Procédé selon la revendication 10 dans lequel l'atmosphère non-oxydante est un gaz inerte incluant un gaz réducteur.

12. Procédé selon la revendication 11 dans lequel le gaz inerte inclut 5 à 15 % en volume de gaz hydrogène.

13. Procédé selon l'une quelconque des revendications 5 à 12 dans lequel le diamètre de ladite bille (7) est 1,5 à 4 fois celui dudit fil métallique (1).

14. Procédé selon la revendication 13 dans lequel le diamètre de ladite bille (7) est 2,5 à 3,5 fois celui dudit fil métallique (1).
